(19) Europäisches Patentamt / European Patent Office / Office européen des brevets

(11) **EP 1 663 897 B1**

(12) **FASCICULE DE BREVET EUROPEEN**

(45) Date de publication et mention
de la délivrance du brevet:
**02.09.2009 Bulletin 2009/36**

(21) Numéro de dépôt: **04786318.8**

(22) Date de dépôt: **18.08.2004**

(51) Int Cl.:
**C03C 17/36** (2006.01)

(86) Numéro de dépôt international:
**PCT/FR2004/002152**

(87) Numéro de publication internationale:
**WO 2005/028391 (31.03.2005 Gazette 2005/13)**

(54) **SUBSTRAT TRANSPARENT MUNI D'UN EMPILEMENT DE COUCHES MINCES POUR UN BLINDAGE ELECTROMAGNETIQUE**

TRANSPARENTES SUBSTRAT MIT EINEM STAPEL VON DÜNNEN SCHICHTEN FÜR ELEKTROMAGNETISCHE ABSCHIRMUNG

TRANSPARENT SUBSTRATE COMPRISING A STACK OF THIN LAYERS FOR ELECTROMAGNETIC ARMOUR

(84) Etats contractants désignés:
**AT BE BG CH CY CZ DE DK EE ES FI FR GB GR HU IE IT LI LU MC NL PL PT RO SE SI SK TR**

(30) Priorité: **17.09.2003 FR 0310912**

(43) Date de publication de la demande:
**07.06.2006 Bulletin 2006/23**

(73) Titulaire: **SAINT-GOBAIN GLASS FRANCE**
**92400 Courbevoie (FR)**

(72) Inventeurs:
• **FLEURY, Carinne**
**F-75015 Paris (FR)**
• **BELLIOT, Sylvain**
**F-75012 Paris (FR)**
• **MAINPIN, Estelle**
**F-75005 Paris (FR)**

(74) Mandataire: **Aupetit, Muriel J. C.**
**Saint-Gobain Recherche**
**39, Quai Lucien Lefranc**
**93300 Aubervilliers (FR)**

(56) Documents cités:
**US-A1- 2003 049 464        US-B1- 6 572 940**

EP 1 663 897 B1

**Description**

L'invention a pour objet un substrat transparent, notamment en verre, qui est revêtu d'un empilement de couches minces, comprenant au moins une couche métallique, pour le blindage électromagnétique.

L'invention sera plus particulièrement décrite pour l'utilisation d'un tel substrat dans un écran plasma, néanmoins elle n'est pas limitée à une telle application, le substrat pouvant être inséré dans toute paroi de blindage électromagnétique.

Un écran plasma comporte un mélange de gaz plasmagène (Ne, Xe, Ar) emprisonné entre deux feuilles de verre, et des luminophores disposés sur la face interne de la feuille arrière de l'écran. Le rayonnement lumineux ultraviolet émis par le mélange de gaz plasmagène lors de la décharge plasma entre les deux feuilles de verre interagit avec les luminophores de la face interne de la feuille arrière pour produire le rayonnement lumineux visible (rouge, vert, bleu). Un mécanisme de désexcitation des particules de gaz entre en compétition avec l'émission U.V., ce qui engendre un rayonnement infrarouge entre 800 et 1250 nm dont la propagation, principalement au travers de la face avant de l'écran, peut être à l'origine de perturbations très gênantes, notamment pour les équipements situés à proximités et commandés par infra-rouge, par exemple au moyen de télécommandes.

Par ailleurs, comme tous les appareils électroniques, les écrans plasma possèdent des systèmes d'adressage (drivers) qui peuvent générer un rayonnement parasite vis-à-vis d'autres dispositifs avec lesquels ils ne doivent pas interférer tels que microordinateurs, téléphones portables...

Afin d'annihiler, et pour le moins réduire, la propagation de ces rayonnements, une solution consiste à disposer contre la face avant de l'écran une fenêtre, nommée encore filtre, à la fois transparente et métallisée pour assurer un blindage électromagnétique. Ce filtre est par exemple un substrat transparent recouvert de couches minces à base d'argent qui réfléchissent les ondes électromagnétiques sur une plage de fréquence de 30 MHz à 1 GHz et les infrarouges au-delà de 800 nm.

Ainsi, le brevet FR 2641272 propose un substrat comprenant une couche réfléchissante d'argent prise en sandwich entre une sous-couche transparente qui comprend au moins une couche d'un oxyde métallique, et une couche de recouvrement transparente qui comprend une couche d'un oxyde de métal sacrificiel, une couche d'oxyde de zinc dont l'épaisseur n'est pas supérieure à 15 nm, et une couche supérieure de recouvrement d'un oxyde métallique.

La couche d'argent présente une épaisseur de préférence comprise entre 8 et 12 nm.

La couche d'oxyde métallique de la sous-couche peut être choisie parmi plusieurs oxydes et être un mélange de plusieurs oxydes. Un exemple préféré est une couche de dioxyde de titane et une couche d'oxyde d'étain déposée sur ledit dioxyde de titane.

L'oxyde de métal sacrificiel a pour but de protéger la couche d'argent contre l'oxydation, en particulier lors de son dépôt quand ce dernier est réalisé par la technique de pulvérisation cathodique. En effet, si l'argent est altéré, le substrat revêtu perd sa faible émissivité et sa transmission lumineuse est fortement réduite. Le métal sacrificiel souvent préféré est le titane car il procure une protection très efficace contre l'oxydation de l'argent et présente l'avantage d'être facilement oxydé et de former un oxyde à très faible pouvoir absorbant.

La couche d'oxyde de zinc sert de protection contre la pénétration d'oxygène dans les couches inférieures et permet une certaine réduction de l'épaisseur de métal sacrificiel qui est alors plus facilement, plus complètement et plus uniformément oxydé. Ce document exige une épaisseur limitée pour la couche d'oxyde de zinc à 15 nm, pour notamment conférer à la couche de bonnes propriétés de transmission lumineuse.

Cependant, un tel substrat avec une seule couche métallique ne convient pas pour obtenir un blindage électromagnétique suffisant, tel que présentant une résistance par carré inférieure à 1,8 Ω/□. Aussi, d'autres demandes de brevets proposent des empilements avec une pluralité de couches métalliques, en particulier des couches d'argent. Toutefois, on sait que l'augmentation des couches diminue la transmission lumineuse; un compromis sur les épaisseurs et types de couches doit donc être trouvé pour permettre une transmission lumineuse satisfaisante.

La demande de brevet publiée WO 01/81262 propose un empilement avec deux couches d'argent d'épaisseur $e_1$ pour la couche d'argent la plus proche du substrat et d'épaisseur $e_2$ pour l'autre couche, un oxyde de métal sacrificiel tel que du titane étant placé au-dessus de chaque couche d'argent pour sa protection. Un exemple de séquence est la suivante :

Substrat/$Si_3N_4$/ZnO/Ag/Ti/$Si_3N_4$/ZnO/Ag/Ti/ZnO/$Si_3N_4$

Pour parvenir à une résistance par carré inférieure à 1,8 Ω/□ tout en gardant une transmission lumineuse convenable, le rapport des épaisseurs $\frac{e_1}{e_2}$ est compris entre 0,8 et 1,1, de préférence entre 0,9 et 1, et l'épaisseur totale des couches métalliques $e_1+e_2$ est comprise entre 27,5 et 30 nm, de préférence entre 28 et 29,5 nm.

La demande de brevet européen EP 1 155 816 décrit un empilement avec trois, voire quatre, couches d'argent avec une alternance d'une couche d'oxyde de titane et d'une couche présentant un indice de réfraction inférieur à 2,4 à la longueur d'onde de 550 nm, tel que par exemple de l'oxyde de zinc ou de préférence du nitrure de silice. L'épaisseur de la couche d'argent la plus proche du substrat et de celle la plus éloignée est de préférence égale de 0,5 à 1 fois l'épaisseur de l'autre couche d'argent. Un exemple de séquence présentant une résistance par carré égale à 1,5 $\Omega/\square$ avec une transmission lumineuse de 67% est donné avec trois couches d'argent dopé au palladium ayant une épaisseur chacune de 16 nm. Cette séquence est la suivante :

$$\text{Substrat/TiO}_x/\text{SiN}_x/\text{Ag/ SiN}_x/\text{TiO}_x/\text{SiN}_x/\text{Ag/SiN}_x/\text{TiO}_x/\text{SiN}_x/\text{Ag/ SiN}_x/\text{TiO}_x$$

Le document US 2003/0 049 464 propose un verre revêtu de l'empilement bas-émissif tel qu'indiqué ci-dessous : substrat/TiO$_x$ ou SiN$_x$/ZnO/Ag/couche sacrificiale de métal oxydé/TiO$_x$ ou SiN$_x$/ZnO/Ag/couche sacrificielle de métal oxydé/SiN$_x$.

Mais il est toujours souhaitable d'accroître encore davantage les propriétés des solutions existantes, obtenir ainsi une diminution encore sensible de la résistance par carré sans dégrader la transmission lumineuse.

L'invention a donc pour but de trouver une autre solution de filtre, notamment pour écran plasma, pour pallier au problème de la transmission d'ondes électromagnétiques, tout en parvenant à des propriétés optiques satisfaisantes.

Selon l'invention, le substrat transparent, notamment en verre, muni d'un empilement de couches minces comportant trois couches d'argent, et de manière alternative sur le substrat, une couche de dioxyde de titane, une couche d'oxyde de métal, l'une des couches d'argent, et une couche de revêtement, est **caractérisé en ce que**

- les épaisseurs ($e_{Ag1}$, $e_{Ag2}$, $e_{Ag3}$) des couches respectives (Ag$_1$, Ag$_2$, Ag$_3$) varient selon un rapport compris entre 0,8 et 1,2 et sont telles que $e_{Ag1} \leq e_{Ag3} \leq e_{Ag2}$,
- l'oxyde de métal est de l'oxyde de zinc,
- la couche de revêtement est un métal sacrificiel et présente une épaisseur inférieure ou égale à 2 nm, et
- sur la couche de revêtement de la couche d'argent la plus éloignée du substrat est déposée une couche anti-reflet comportant au moins un oxyde de métal.

Selon une caractéristique, l'épaisseur de chacune des couches d'argent est comprise entre 13 nm et 19 nm

Selon une autre caractéristique, la couche de dioxyde de titane en sous-couche de la couche d'argent proche du substrat (Ag$_1$) présente une épaisseur comprise entre 10 et 20 nm, de préférence entre 10 et 15 nm, et les couches d'oxyde de titane en sous-couche des deux autres couches d'argent (Ag$_2$, Ag$_3$) présentent une épaisseur comprise entre 35 et 55 nm, et de préférence entre 40 et 50 nm.

De préférence, la couche d'oxyde de zinc présente une épaisseur supérieure à 15 nm.

Avantageusement, la couche de métal sacrificiel est du niobium, du titane, ou du zirconium.

Selon une autre caractéristique, la couche anti-reflet présente une épaisseur comprise entre 25 et 50 nm, de préférence entre 25 et 35 nm. Cette couche anti-reflet comporte avantageusement au moins une couche de dioxyde de titane qui présente une épaisseur comprise entre 15 et 35 nm, de préférence entre 20 et 30 nm, et peut comporter aussi une autre couche d'un oxyde de métal qui est déposée sur ladite couche de dioxyde de titane et qui présente une épaisseur comprise entre 5 et 15 nm, de préférence entre 6 et 10 nm. Cette couche d'oxyde de métal est plutôt de l'oxyde d'étain (SnO$_2$) ou du nitrure de silice (Si$_3$N$_4$).

Avec de telles caractéristiques, le substrat selon l'invention présente une résistance par carré inférieure ou égale à 1 $\Omega/\square$, de préférence comprise entre 0,7 et 0,9 $\Omega/\square$.

Le substrat pourra être en verre trempé ou non, ou en matière plastique.

On utilisera avantageusement un tel substrat dans un filtre de blindage électromagnétique, appliqué par exemple à un écran de visualisation de type écran plasma. Ce filtre comporte donc un substrat muni de l'empilement de l'invention, et en association, une ou plusieurs feuilles fonctionnelles de matière plastique (par exemple avec des pigments ou des colorants) et/ou un autre substrat transparent revêtu éventuellement d'une couche anti-reflet, de façon à présenter les propriétés optiques suivantes:

- un taux de transmission lumineuse T$_L$ compris entre 45 et 55%,
- une pureté inférieure à 10% en transmission,
- une réflexion lumineuse R$_L$ inférieure à 5%, de préférence inférieure à 4%,
- une couleur en réflexion à dominance bleu-violet de pureté inférieure à 20%,
- une couleur en transmission à dominance bleue.

D'autres caractéristiques et avantages de l'invention vont à présent être décrits en regard des dessins annexés sur lesquels :

- la figure 1 illustre un premier mode de réalisation d'un filtre de blindage électromagnétique;
- la figure 2 illustre un second mode de réalisation d'un filtre de blindage électromagnétique;
- la figure 3 illustre schématiquement l'empilement de l'invention.

On précise tout d'abord que les proportions relatives aux différentes grandeurs, notamment épaisseurs, des éléments de l'invention ne sont pas respectées sur les dessins afin que la lecture en soit facilitée.

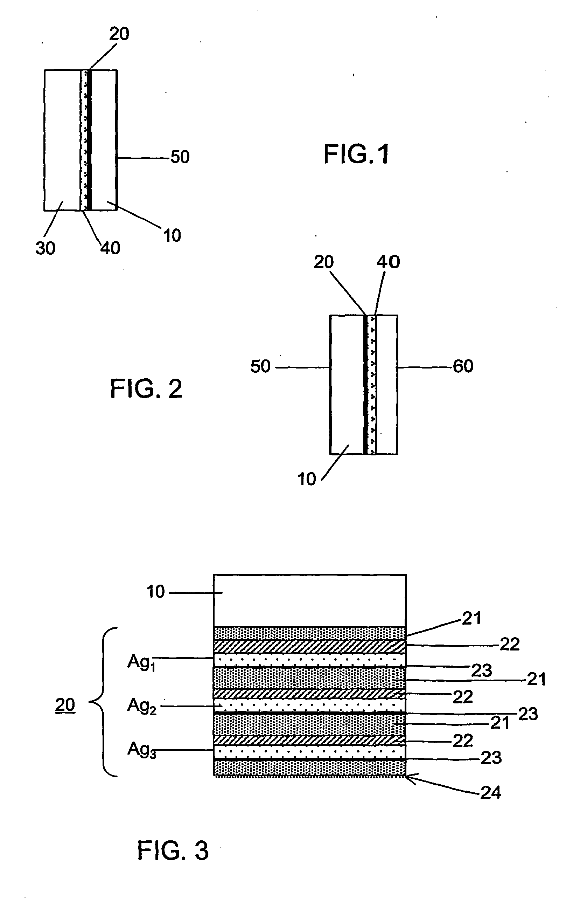

La figure 1 illustre un premier exemple de mode de réalisation de la structure 1 transparente destinée à être assemblée sur la face avant d'un écran plasma pour constituer un filtre optique et de blindage électromagnétique.

La structure 1 comporte un premier substrat 10 transparent du type verrier par exemple, mais qui pourrait être en variante en matière plastique, destiné à être agencé du côté de l'écran, un empilement 20 de couches minces selon l'invention qui est disposé sur la face interne du substrat 10, vers l'intérieur de la structure, un second substrat 30 du type verrier qui est associé au premier substrat en regard de l'empilement 20 au moyen d'un film plastique 40 tel que du PVB. Ce film plastique fonctionnel peut avantageusement intégrer un pigment minéral ou un colorant organique de façon à réaliser un filtre dans la couleur orange de longueur d'onde centrée sur 590 nm. On se reportera pour plus de détails sur le film plastique ou pour des variantes de réalisation de la structure à la demande de brevet français FR 03/04636.

Les faces externes des substrats 10 et 30 à l'extérieur de la structure sont de préférence munies d'un revêtement anti-reflet 50.

La figure 2 illustre un second exemple de mode de réalisation de la structure 1 qui comporte ici un substrat 10 dont l'une des faces, destinée à être à l'opposé du spectateur, est munie de l'empilement 20 de couches minces, et un substrat 60 en matière plastique, telle que du PET, qui est destiné à être agencé du côté de l'écran et qui est associé au substrat 10 en regard de l'empilement 20 au moyen d'un film plastique 40 tel que du PVB qui peut avantageusement intégrer d'autres fonctionnalités comme décrit ci-dessus dans le premier mode de réalisation. La face externe du substrat 10, à l'extérieur de la structure, est de préférence munie d'un revêtement anti-reflet 50.

L'invention porte donc sur l'empilement 20 déposé sur un substrat tel que le substrat 10. Cet empilement comporte trois couches métalliques en argent, la plus près du substrat $Ag_1$, la médiane $Ag_2$ et la plus éloignée $Ag_3$, dont la fonction est de réfléchir les ondes électromagnétiques de fréquence comprise entre 30MHz et 1 GHz et les ondes infrarouges au-delà de 800 nm.

L'empilement comporte de manière alternative déposées sur le substrat une couche de dioxyde de titane 21, une couche d'un oxyde métallique 22 constitué d'oxyde de zinc, l'une des couches d'argent $Ag_1$, $Ag_2$ et $Ag_3$, et une couche d'un revêtement 23 de métal sacrificiel. Au-dessus de la couche 23 de métal sacrificiel déposée sur la couche d'argent la plus éloignée du substrat $Ag_3$ est déposée une couche anti-reflet 24 constituée d'au moins un oxyde de métal.

L'épaisseur de chacune des couches d'argent $Ag_1$, $Ag_2$ et $Ag_3$ est comprise entre 13 nm et 19 nm. Les épaisseurs $e_{Ag1}$, $e_{Ag2}$ et $e_{Ag3}$ des couches respectives $Ag_1$, $Ag_2$ et $Ag_3$ peuvent être identiques ou varier selon un rapport compris entre 0,8 et 1,2 et sont telles que $e_{Ag1} \leq e_{Ag3} \leq e_{Ag2}$. Le déséquilibre d'épaisseur des couches sera privilégié pour abaisser la réflexion lumineuse tout en conservant la même résistance par carré.

La couche d'oxyde de titane 21 en sous-couche de la couche d'argent proche du substrat $Ag_1$ présente une épaisseur comprise entre 10 et 20 nm, de préférence entre 10 et 15 nm.

Les couches d'oxyde de titane 21 en sous-couche des deux autres couches d'argent $Ag_2$ et $Ag_3$ présentent une épaisseur comprise entre 35 et 55 nm, et de préférence entre 40 et 50 nm.

La couche d'oxyde de zinc 22 présente une épaisseur de préférence supérieure à 15 nm, par exemple de 16 ou 18 nm.

La couche de métal sacrificiel 23 est du niobium, du titane ou du zirconium, de préférence du titane, et présente une épaisseur d'au plus 2 nm, par exemple 1,5 nm.

Cette couche de métal sacrificiel permet de protéger l'argent contre l'oxydation, et d'améliorer sa résistivité. Bien que la présence de titane puisse dégrader la transmission lumineuse, elle permet d'obtenir une résistance par carré encore plus basse tout en gardant une transmission lumineuse suffisamment correcte. Le compromis à trouver entre les qualités optiques du filtre et ses qualités de blindage est assuré en privilégiant le blindage tout en gardant encore de bonnes qualités optiques. Ainsi, avec la séquence de l'invention à base de trois couches d'argent, la résistance par carré descend jusqu'à 0,8 $\Omega/\square$ au lieu de 1,5 selon l'état de la technique, ce qui permet de répondre non seulement à la classe A de la norme EN55022 s'adressant aux produits dits "grand public" mais aussi à la classe B s'adressant aux produits du particulier du type home-cinéma.

La couche anti-reflet 24 de la couche d'argent éloignée du substrat $Ag_3$ présente une épaisseur comprise entre 25 et 50 nm, de préférence entre 25 et 35 nm. Elle comporte au moins du dioxyde de titane d'épaisseur comprise entre 15 et 35 nm, de préférence entre 20 et 30 nm.

Avantageusement, au-dessus du dioxyde de titane de cette couche anti-reflet est déposé un autre oxyde de métal en faible épaisseur, entre 5 et 15 nm, et de préférence entre 6 et 10 nm. Cet oxyde de métal est par exemple de l'oxyde d'étain ($SnO_2$) ou du nitrure de silice ($Si_3N_4$), il permet d'améliorer la pureté des couleurs en réflexion et en transmission.

Toutes les couches de l'empilement sont déposées par une technique connue de pulvérisation cathodique sur le substrat.

Nous donnons dans le tableau ci-après cinq exemples pour l'empilement 20 de l'invention (ex1 à ex5). Sont fournies les épaisseurs en nm de chaque couche et, pour chaque empilement associé à un substrat 10, les taux de transmission lumineuse $T_L$ (en %), de réflexion lumineuse $R_L$ (en %), de pureté en transmission $p_e$ en T (en %), de pureté en réflexion $p_e$ en R (en %), les longueurs d'onde dominante en transmission et en réflexion, respectivement $\lambda_d$ en T et $\lambda_d$ en R (en nm), et la résistance par carré (en $\Omega$).

Ces cinq exemples permettent d'obtenir le blindage adéquat inférieur à 1 $\Omega/\square$.

Pour les exemples 1, 2 et 5, les couches d'argent sont identiques et égales à 15 nm; sont différentes les épaisseurs d'oxyde de zinc, avec une épaisseur inférieure à 15 nm, égale exactement à 10 pour l'exemple 5. Pour chaque exemple, l'épaisseur des couches de dioxyde de titane est fixée de manière à optimiser les propriétés optiques de l'empilement.

Les résultats montrent que pour les exemples 1 et 2 qui présentent des épaisseurs supérieures en oxyde de zinc par rapport à l'exemple 5 (de 6 à 8 nm en plus), la transmission lumineuse, contrairement à ce que l'on pourrait penser en regard de l'état de la technique, reste sensiblement identique et même un peu meilleure pour l'exemple 1 d'épaisseur en oxyde de zinc de 18 nm, et la réflexion a l'avantage pour les exemples 1 et 2 d'être plus basse que pour l'exemple 5, ce qui permet d'obtenir un éclairage de l'écran moins lumineux et agressif pour le spectateur.

Les exemples 3 et 4 présentent en comparaison, des épaisseurs inégales pour les couches d'argent, avec pour l'exemple 4, une couche anti-reflet 25 à base de $SnO_2$. On voit que le déséquilibre a l'avantage de diminuer la réflexion lumineuse mais avec l'inconvénient d'augmenter la pureté en transmission et en réflexion; or, l'addition de la couche anti-reflet permet de pallier à cet inconvénient et d'obtenir ainsi une pureté en transmission équivalente ou sensiblement équivalente à celle des exemples 1, 2 et 5, et de diminuer la pureté en réflexion par rapport à celle de l'exemple 3.

|  | ex1 | ex2 | ex3 | ex4 | ex5 |
|---|---|---|---|---|---|
| $TiO_2$ | 12 | 12 | 12 | 12 | 13 |
| ZnO | 18 | 16 | 16 | 16 | 10 |
| $Ag_1$ | 15 | 15 | 13,5 | 13,5 | 15 |
| Ti | 1,5 | 1,5 | 1,5 | 1,5 | 1,6 |
| $TiO_2$ | 43 | 43 | 43 | 43 | 48 |
| ZnO | 18 | 16 | 16 | 16 | 10 |
| $Ag_2$ | 15 | 15 | 16,5 | 16,5 | 15 |
| Ti | 1,5 | 1,5 | 1,5 | 1,5 | 1,5 |
| $TiO_2$ | 43 | 43 | 43 | 43 | 48 |
| ZnO | 18 | 16 | 16 | 16 | 10 |
| $Ag_3$ | 15 | 15 | 15 | 15 | 15 |
| Ti | 1,5 | 1,5 | 1,5 | 1,5 | 1,5 |
| $TiO_2$ | 25 | 25 | 25 | 25 | 25 |
| $SnO_2$ | 0 | 0 | 0 | 7 | 0 |
| $T_L$ en % | 62 | 61 | 62 | 65 | 61 |
| $R_L$ en % | 5,8 | 5,0 | 4,7 | 4,7 | 6 |
| $p_e$ en T (%) | 5 | 6 | 9 | 6 | 5 |
| $\lambda_d$ en T (nm) | 500 | 490 | 496 | 499 | 500 |
| $p_e$ en R (%) | 30 | 20 | 50 | 40 | 30 |
| $\lambda_d$ en R (nm) | -555 | -560 | -553 | -547 | -555 |
| $R/\square$ ($\Omega$) | 0,8 | 0,8 | 0,8 | 0,8 | 0,8 |

Ainsi, par la maîtrise du dépôt des couches d'argent et de diélectrique et des épaisseurs formulées selon l'invention ainsi que par l'utilisation de couches de protection métallique, le filtre obtenu en référence à la figure 1 ou à la figure 2 présente les propriété suivantes :

- une résistance par carré inférieure à 1 Ω/□,
- un taux de transmission lumineuse $T_L$ compris entre 45 et 55%,
- une pureté inférieure à 10% en transmission,
- une réflexion lumineuse $R_L$ inférieure à 5%, de préférence inférieure à 4%,
- une couleur en réflexion à dominance bleu-violet de pureté inférieure à 20%,
- une couleur en transmission à dominance bleue.

Le filtre de blindage électromagnétique utilisant le substrat de l'invention peut être appliqué à un écran de visualisation, en particulier un écran plasma. Il assure une très bonne performance pour le blindage (la résistance par carré étant inférieure à 1 Ω/□), et par conséquent bloque notamment les infra-rouges avec une transmission à 900nm qui n'excède pas 1%. Ce filtre assure par ailleurs une bonne visibilité -un taux de transmission lumineuse entre 45 et 55%- et améliore le contraste de l'écran.

**Revendications**

**1.** Substrat transparent, notamment en verre, muni d'un empilement de couches minces (20) comportant trois couches d'argent (Ag1, Ag2, Ag3), et de manière alternative sur le substrat, une couche de dioxyde de titane (21), une couche d'oxyde de métal (22), l'une des couches d'argent (Ag1, Ag2, Ag3), et une couche de revêtement (23), **caractérisé en ce que**

- les épaisseurs ($e_{Ag1}$, $e_{Ag2}$, $e_{Ag3}$) des couches respectives ($Ag_1$, $Ag_2$, $Ag_3$) varient selon un rapport compris entre 0,8 et 1,2 et sont telles que $e_{Ag1} \leq e_{Ag3} \leq e_{Ag2}$.
- l'oxyde de métal est de l'oxyde de zinc,
- la couche de revêtement (23) est un métal sacrificiel et présente une épaisseur inférieure ou égale à 2 nm, et
- sur la couche de revêtement (23) de la couche d'argent ($Ag_3$) la plus éloignée du substrat est déposée une couche anti-reflet (24) comportant au moins un oxyde de métal.

**2.** Substrat selon la revendication 1, **caractérisé en ce que** l'épaisseur de chacune des couches d'argent ($Ag_1$, $Ag_2$, $Ag_3$) est comprise entre 13 nm et 19 nm.

**3.** Substrat selon l'une des revendications 1 à 2, **caractérisé en ce que** la couche de dioxyde de titane (21) en sous-couche de la couche d'argent proche du substrat ($Ag_1$) présente une épaisseur comprise entre 10 et 20 nm, de préférence entre 10 et 15 nm, et les couches d'oxyde de titane (21) en sous-couche des deux autres couches d'argent ($Ag_2$, $Ag_3$) présentent une épaisseur comprise entre 35 et 55 nm, et de préférence entre 40 et 50 nm.

**4.** Substrat selon l'une quelconque des revendications précédentes, **caractérisé en ce que** la couche d'oxyde de zinc (22) présente une épaisseur supérieure à 15 nm.

**5.** Substrat selon l'une quelconque des revendications précédentes, **caractérisé en ce que** la couche de métal sacrificiel (23) est du niobium (Nb), du titane (Ti), ou du zirconium (Zr).

**6.** Substrat selon l'une quelconque des revendications précédentes, **caractérisé en ce que** la couche anti-reflet (24) présente une épaisseur comprise entre 25 et 50 nm, de préférence entre 25 et 35 nm.

**7.** Substrat selon la revendication 6, **caractérisé en ce que** la couche anti-reflet (24) comporte au moins une couche de dioxyde de titane qui présente une épaisseur comprise entre 15 et 35 nm, de préférence entre 20 et 30 nm.

**8.** Substrat selon l'une des revendications 6 ou 7, **caractérisé en ce que** la couche anti-reflet (24) comporte une couche de dioxyde de titane et une autre couche d'un oxyde de métal qui est déposée sur ladite couche de dioxyde de titane et présente une épaisseur comprise entre 5 et 15 nm, de préférence entre 6 et 10 nm.

**9.** Substrat selon la revendication 8, **caractérisé en ce que** la couche d'oxyde de métal de la couche anti-reflet (24) est de l'oxyde d'étain ($SnO_2$) ou du nitrure de silice ($Si_3N_4$).

**EP 1 663 897 B1**

10. Substrat selon l'une quelconque des revendications précédentes, **caractérisé en ce qu'**il présente une résistance par carré inférieure ou égale à 1 Ω/□, de préférence comprise entre 0,7 et 0,9 Ω/□.

11. Substrat selon l'une quelconque des revendications précédentes, **caractérisé en ce qu'**il est en verre trempé ou non, ou en matière plastique.

12. Filtre de blindage électromagnétique comportant un substrat selon l'une quelconque des revendications précédentes, **caractérisé en ce qu'**il présente les propriétés optiques suivantes :

   - un taux de transmission lumineuse $T_L$ compris entre 45 et 55%,
   - une pureté inférieure à 10% en transmission,
   - une réflexion lumineuse $R_L$ inférieure à 5%, de préférence inférieure à 4%,
   - une couleur en réflexion à dominance bleu-violet de pureté inférieure à 20%,
   - une couleur en transmission à dominance bleue.

13. Ecran de visualisation du type écran plasma incorporant sur sa face avant au moins un substrat ou filtre selon l'une quelconque des revendications 1 à 12.

**Claims**

1. A transparent substrate, especially made of glass, provided with a thin-film multilayer (20) that includes three silver layers (Ag1, Ag2, Ag3) and comprises, alternately on the substrate, a titanium dioxide layer (21), a metal oxide layer (22), one of the silver layers (Agl1 Ag2, Ag3) and a covering layer (23), **characterized in that**:

   - the thicknesses ($e_{Ag1}$, $e_{Ag2}$, $e_{Ag3}$) of the respective layers ($Ag_1$, $Ag_2$, $Ag_3$) vary in a ratio of between 0.8 and 1.2 and are such that $e_{Ag1} \leq e_{Ag3} \leq e_{Ag2}$;
   - the metal oxide is zinc oxide;
   - the covering layer (23) is a sacrificial metal and has a thickness not exceeding 2 nm; and
   - an antireflection layer (24) comprising at least one metal oxide is deposited on the covering layer (23) for the silver layer ($Ag_3$) furthest away from the substrate.

2. The substrate as claimed in claim 1, **characterized in that** the thickness of each of the silver layers ($Ag_1$, $Ag_2$, $Ag_3$) is between 13 nm and 19 nm.

3. The substrate as claimed in one of claims 1 or 2, **characterized in that** the titanium dioxide layer (21) as sublayer for the silver layer ($Ag_1$) closest to the substrate has a thickness of between 10 and 20 nm, preferably between 10 and 15 nm, and the titanium oxide layers (21) as sublayers for the other two silver layers ($Ag_2$, $Ag_3$) have a thickness of between 35 and 55 nm, preferably between 40 and 50 nm.

4. The substrate as claimed in any one of the preceding claims, **characterized in that** the zinc oxide layer (22) has a thickness of greater than 15 nm.

5. The substrate as claimed in any one of the preceding claims, **characterized in that** the sacrificial metal layer (23) is of niobium (Nb), titanium (Ti) or zirconium (Zr).

6. The substrate as claimed in any one of the preceding claims, **characterized in that** the antireflection layer (24) has a thickness of between 25 and 50 nm, preferably between 25 and 35 nm.

7. The substrate as claimed in claim 8, **characterized in that** the antireflection layer (24) includes at least one titanium dioxide layer having a thickness of between 15 and 35 nm, preferably between 20 and 30 nm.

8. The substrate as claimed in either of claims 6 or 7, **characterized in that** the antireflection layer (24) includes a titanium dioxide layer and another layer of a metal oxide that is deposited on said titanium dioxide layer and has a thickness of between 5 and 15 nm, preferably between 6 and 10 nm.

9. The substrate as claimed in claim 8, **characterized in that** the metal oxide layer of the antireflection layer (24) is tin oxide ($SnO_2$) or silicon nitride ($Si_3N_4$).

7

10. The substrate as claimed in any one of the preceding claims, **characterized in that** it has a surface resistance not exceeding 1 Ω/□, preferably between 0.7 and 0.9 Ω/□.

11. The substrate as claimed in any one of the preceding claims, **characterized in that** it is made of toughened or untoughened glass, or made of plastic.

12. An electromagnetic shielding filter comprising a substrate as claimed in any one of the preceding claims, **characterized in that** it has the following optical properties:

      - a light transmission factor $T_L$ of between 45 and 55%;
      - a purity of less than 10% in transmission;
      - a light reflection $R_L$ of less than 5%, preferably less than 4%;
      - a predominantly violet-blue color in reflection with a purity of less than 20%;
      - a predominantly blue color in transmission.

13. A display screen of the plasma display type incorporating, on its front face, at least one substrate or filter as claimed in any one of claims 1 to 12.

**Patentansprüche**

1. Transparentes Substrat, insbesondere aus Glas, welches mit einem Stapel von Dünnschichten (20) versehen ist, umfassend drei Silberschichten (Ag1, Ag2, Ag3) und abwechselnd auf dem Substrat eine Titandioxidschicht (21), eine Metalloxidschicht (22), wobei eine von den Silberschichten (Ag1, Ag2, Ag3) und eine Überzugsschicht (23) **dadurch gekennzeichnet sind, dass:**

      - die Dicken ($e_{Ag1}$, $e_{Ag2}$, $e_{Ag3}$), der entsprechenden Schichten ($Ag_1$, $Ag_2$, $Ag_3$) in einem Verhältnis zwischen 0,8 und 1,2 variieren und so sind, dass $e_{Ag1} \leq e_{Ag3} \leq e_{Ag2}$ gilt.
      - das Metalloxid Zinkoxid ist,
      - die Überzugsschicht (23) ein Opfermetall ist und eine Dicke kleiner oder gleich 2 nm aufweist, und
      - auf der Überzugsschicht (23) der Silberschicht ($Ag_3$), die dem Substrat am meisten entfernt liegt, eine antireflektierende Schicht (24) aufgebracht ist, welche zumindest ein Metalloxid aufweist.

2. Substrat gemäß Anspruch 1, **dadurch gekennzeichnet, dass** die Dicke jeder der Silberschichten ($Ag_1$, $Ag_2$, $Ag_3$) zwischen 13 nm und 19 nm liegt.

3. Substrat nach einem der Ansprüche 1 bis 2, **dadurch gekennzeichnet, dass** die Titandioxidschicht (21), eine Unterschicht der Silberschicht nahe dem Substrat ($Ag_1$) eine Dicke aufweist, welche zwischen 10 und 20 nm, vorzugsweise zwischen 10 und 15 nm liegt und die Titanoxidschichten (21), Teilschichten der zwei andren Silberschichten ($Ag_2$, $Ag_3$), eine Dicke aufweisen, die zwischen 35 und 55 nm, vorzugsweise zwischen 40 und 50 nm liegt.

4. Substrat nach einem der vorhergehenden Ansprüche, **dadurch gekennzeichnet, dass** die Zinkoxidschicht (22) eine Dicke größer als 15 nm aufweist.

5. Substrat nach einem der vorhergehenden Ansprüche, **dadurch gekennzeichnet, dass** die Opfermetallschicht (23) aus Niobium (Nb), Titan (Ti) oder aus Zirkonium (Zr) ist.

6. Substrat nach einem der vorhergehenden Ansprüche, **dadurch gekennzeichnet, dass** die antireflektierende Schicht (24) eine Dicke aufweist, welche zwischen 25 und 50 nm, vorzugsweise zwischen 25 und 35 nm, liegt.

7. Substrat nach Anspruch 6, **dadurch gekennzeichnet, dass** die antireflektierende Schicht (24) mindestens eine Titandioxidschicht aufweist, welche eine Dicke zwischen 15 und 35 nm, vorzugsweise zwischen 20 und 30 nm aufweist.

8. Substrat nach einem der Ansprüche 6 oder 7, **dadurch gekennzeichnet, dass** die antireflektierende Schicht (24) eine Titandioxidschicht aufweist und eine andere Metalloxidschicht, welche auf die besagte Titandioxidschicht aufgetragen ist und eine Dicke aufweist, welche zwischen 5 und 15 nm, vorzugsweise zwischen 6 und 10 nm, liegt.

9. Substrat nach Anspruch 8, **dadurch gekennzeichnet, dass** die Metalloxidschicht der antireflektierenden Schicht (24) aus Zinnoxid ($SnO_2$) oder aus Siliziumnitrid ($Si_3N_4$) besteht.

10. Substrat nach irgendeinem der vorhergehenden Ansprüche, **dadurch gekennzeichnet, dass** dieses einen Widerstand pro Quadrat von kleiner oder gleich 1 $\Omega/\square$, vorzugsweise zwischen 0,7 und 0,9 $\Omega/\square$, aufweist.

11. Substrat nach einem der vorhergehenden Ansprüche, **dadurch gekennzeichnet, dass** dieses aus vorgespanntem oder nicht vorgespanntem Glas, oder aus Plastik besteht.

12. Elektromagnetischer Abschirmfilter, welcher ein Substrat nach einem der vorhergehenden Ansprüche aufweist, **dadurch gekennzeichnet, dass** dieser die folgenden optischen Merkmale aufweist:

   - eine luminöse Übertragungsrate $T_L$ zwischen 45 und 55 %,
   - eine Reinheit kleiner 10 % bei Übertragung,
   - eine Leuchtrefflektion $R_L$ kleiner 5 %, vorzugsweise kleiner 4 %,
   - eine Reflektionsfarbe mit Dominanz im blau-violetten von einer Reinheit kleiner 20%,
   - eine dominierend blaue Farbe bei Übertragung.

13. Visualisierungsbildschirm der Art Plasmabildschirm, welcher auf seiner Vorderseite mindestens ein Substrat oder einen Filter gemäß einem der Ansprüche 1 bis 12 aufweist.

FIG.1

FIG. 2

FIG. 3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2641272
- WO 0181262 A
- EP 1155816 A
- US 20030049464 A
- FR 0304636